# EUROPÄISCHE PATENTSCHRIFT

(11) **EP 2 988 419 B1**
(45) Veröffentlichungstag und Bekanntmachung des Hinweises auf die Patenterteilung: **14.06.2017**
(21) Anmeldenummer: 15181713.7
(22) Anmeldetag: 20.08.2015
(51) Int. Cl.: H03K 17/18, G05B 19/042, G08B 29/06

(54) **VERFAHREN ZUR ERMITTLUNG DES ZUSTANDS EINES KURZSCHLUSSBILDENDEN MELDEELEMENTS**
METHOD FOR DETERMINING THE STATE OF A REPORTING ELEMENT WHICH FORMS A SHORT CIRCUIT
PROCEDE DE DETERMINATION DE L'ETAT D'UN ELEMENT INDICATEUR FORMANT UN COURT-CIRCUIT

(30) Priorität: 21.08.2014 DE 102014111996
(43) Veröffentlichungstag der Anmeldung: 24.02.2016
(73) Patentinhaber: Wieland Electric GmbH, 96052 Bamberg (DE)
(72) Erfinder: Lindner, Andreas, 14656 Brieselang (DE)
(74) Vertreter: Tergau & Walkenhorst Patentanwälte - Rechtsanwälte

(56) Entgegenhaltungen:
- EP-A1- 2 590 036
- US-A1- 2011 204 729

## Beschreibung

Die Erfindung betrifft ein Verfahren zur Ermittlung des Schaltzustands eines kurzschlussbildenden Meldeelements mit einem ersten Strompfad und einem zweiten Strompfad, die bei Betätigung des Meldeelements kurzgeschlossen werden, bei dem durch eine Sicherheitssteuerung ein erstes logisches Signal in einen Eingang des ersten Strompfades eingespeist wird und ein zweites logisches Signal in einen Eingang des zweiten Strompfades eingespeist wird, wobei die logischen Signale an den Ausgängen der Strompfade von der Sicherheitssteuerung ausgelesen werden.

Sicherheitssteuerungen werden vor allem im industriellen Bereich verwendet, um elektrische Verbraucher sicher ein- und auszuschalten, die Gefahrenpotential für Mensch und Material bergen. Derartige elektrische Verbraucher sind z.B. Pressen, Fräswerkzeuge etc. Hierzu wird die Stromversorgung für den elektrischen Verbraucher über Schaltausgänge der Sicherheitssteuerung gesteuert, die zur Erfüllung der einschlägigen Sicherheitsvorschriften und -zertifizierungen ausgelegt sind. Dazu sind die internen Schaltkreise typischerweise redundant ausgestaltet, z.B. solche zum Ein- und Ausschalten des elektrischen Verbrauchers über zwei in Reihe geschaltete Relais, die von getrennten Stromkreisen gesteuert werden.

Sicherheitssteuerungen weisen üblicherweise eine Anzahl von Schalteingängen und -ausgängen zum Anschluss der Arbeitskontakte eines Meldeelements auf. Das Meldeelement kann z.B. ein Not-Aus-Schalter sein, eine Positions- oder Stellungsüberwachung z.B. einer Schutztür, eine Lichtschranke, eine Schaltmatte etc. Das Meldeelement hat dabei üblicherweise eine je nach Anwendung zu bestimmende Stellung "sicher", z.B. Lichtschranke nicht unterbrochen, d.h. keine Person im Gefahrenbereich, und eine Stellung "nicht sicher", z.B. Schutztürposition offen, d.h. Gefahr. Typischerweise soll die Stromzufuhr zu dem elektrischen Verbraucher dann unterbrochen werden, wenn das Meldeelement nicht mehr in der Position "sicher" ist.

Sicherheitssteuerungen sind häufig auch modular aufgebaut, so dass mehrere, unterschiedlich geartete Meldeelemente angeschlossen werden können. Weiterhin können so auch mehrere elektrische Verbraucher gezielt angesteuert werden. Neben der Überwachung der Schaltstellung der Meldeelemente ist dabei eine ständige Funktionsüberprüfung der Sicherheitssteuerung erforderlich, um die genannten Sicherheitsnormen- und zertifizierungen zu erfüllen. Für besonders hohe Sicherheitsstufen umfasst dies auch eine ständige Prüfung der Verkabelung der angeschlossenen Meldeelemente.

Diese Prüfung erfolgt üblicherweise durch Austastlücken in den logischen Signalen an den Schaltausgängen. Bei zweiwertigen Logiken liegt an den Schaltausgängen entweder eine logische 1 oder eine logische 0 an, die durch bestimmte Spannungswerte unterschieden werden. So kann z.B. der logischen 1 eine Spannung von +24 V und der logischen 0 eine Erdung, d.h. 0 V zugewiesen sein. Um zu erkennen, die an den Schalteingängen gemessene Spannung tatsächlich auch von den Schaltausgängen der Sicherheitssteuerung stammt, wird sie daher in der Sicherheitssteuerung mit regelmäßigen kurzen Austastlücken versehen, d.h. kurzen, definierten Pulsen niedrigerer Spannung, die die ansonsten bestehende, der logischen 1 entsprechende Spannung unterbrechen. Liegt ein Kabelfehler mit z.B. einem Querschluss zu einem anderen Kabel mit entsprechender Spannung vor, ist diese Austastlücke am Schalteingang nicht mehr feststellbar. Die Sicherheitssteuerung kann den Fehler daher am Fehlen der Austastlücken erkennen.

Dieses beschriebene Prinzip wird neben der Querschlusserkennung häufig auch zur Ermittlung des Schaltzustands sogenannter kurzschlussbildender Meldeelemente verwendet. Diese Meldeelemente weisen zwei Strompfade mit jeweils einem Eingang und einem Ausgang auf, die bei Betätigung kurzgeschlossen werden. Zur Ermittlung des Schaltzustands des Meldeelements wird sowohl der erste Eingang als auch der zweite Eingang des Meldeelements mit einem mit Austastlücken versehenen Spannungssignal beaufschlagt. Die Austastlücken sind dabei jedoch zeitlich versetzt, so dass die Austastlücken in den beiden Strompfaden immer zu unterschiedlichen Zeiten auftreten. Wird das Meldeelement betätigt und somit die Strompfade kurzgeschlossen, werden - ebenso wie bei einem Querschluss - die Austastlücken überbrückt und sind an den Ausgängen der Strompfade, die an die Schalteingänge der Sicherheitssteuerung angeschlossen sind, nicht mehr feststellbar. Somit kann die Sicherheitssteuerung die Betätigung des Meldeelements erkennen. Ein derartiges Verfahren ist dem Fachmann beispielsweise aus der US 2011/0204729 A1 bekannt, wenngleich nicht in Bezug auf kurzschlussbildende Meldeelemente.

Da die Erkennung der Betätigung letztlich durch Vergleich von Eingangs- und Ausgangssignal (zeitliche Anordnung der Austastlücken) erfolgt, und bei Betätigung des Meldeelements ein Unterschied nur während einer Austastlücke auftritt, ist hierbei jedoch der Nachteil, dass die Erfassungsgenauigkeit letztlich durch die Frequenz der Austastlücken begrenzt ist. Es ergibt sich somit stets ein Versatz zwischen tatsächlicher Betätigung und Erfassung. Eine sehr kurze Betätigung des Meldeelements wird sogar überhaupt nicht erfasst, wenn sie zwischen zwei Austastlücken erfolgt. Zudem erfordert das System hinsichtlich der Signalauswertung stets die Kenntnis der genauen Position der Austastlücken.

Es ist daher Aufgabe der Erfindung, ein Verfahren der eingangs genannten Art anzugeben, welches in technisch einfacher Weise eine besonders schnelle Erkennung der Betätigung eines kurzschlussbildenden Meldeelements ermöglicht.

Diese Aufgabe wird erfindungsgemäß gelöst, indem zu einem gegebenen Zeitpunkt das erste eingespeiste logische Signal einer 0 entspricht und das zweite eingespeiste logische Signal einer 1 entspricht, die eingespeisten Signale periodisch zwischen einer 1 und einer 0 wechseln, im Betrieb der Sicherheitssteuerung das erste logische Signal zu jedem gegebenen Zeitpunkt dem jeweils anderen logischen Wert entspricht als das zweite logische Signal, und der Zustand des Meldeelements von der Sicherheitssteuerung mittels einer Entweder-Oder-Auswertung der ausgelesenen logischen Signale ermittelt wird.

Die Erfindung geht von der Überlegung aus, dass eine technisch besonders einfache und schnelle Erkennung der Betätigung eines kurzschlussbildenden Meldeelements dadurch erreicht werden könnte, dass die zeitliche Abhängigkeit der Erkennung beispielsweise durch den Abgleich getakteter Austastlücken aufgehoben wird. Dies ist erreichbar, indem die Beschaltung der Strompfade zu einem gegebenen Erkennungszeitpunkt mit entgegengesetzten Logikwerten erfolgt, d.h. auf dem einen Strompfad ein Spannungswert, der dem logischen Signal einer 0 entspricht, und auf dem anderen Strompfad ein Spannungswert, der dem logischen Signal einer 1 entspricht, anliegt. Die Auswertung erfolgt dann in einfacher Weise über eine Entweder-Oder-Auswertung.

Durch die Auswertung der Strompfade mittels einer Entweder-Oder-Auswertung ist die Erkennung der Betätigung des Meldeelements insofern unabhängig von der Beschaltung der Strompfade, als es nur wichtig ist, dass die Strompfade mit unterschiedlichen logischen Signalen beaufschlagt werden. Welcher der beiden Strompfade mit dem logischen Signal 1 und welcher mit dem logischen Signal 0 beaufschlagt ist, ist für die Entweder-Oder-Auswertung irrelevant, da sie dasselbe Ergebnis liefert. Dies kann dazu genutzt werden, die Strompfade auf sogenannte Stuck-At-Fehler zu überwachen, d.h. Querschlüsse zu bestimmten Potentialen, indem nämlich die eingespeisten Signale periodisch zwischen einer 1 und einer 0 wechseln. Ist beispielsweise einer der Strompfade durch einen Leitungsfehler auf ein Spannungsniveau quergeschlossen, welches einer logischen 1 entspricht, wird dieser Fehler nicht erkannt, wenn ohnehin diesem Strompfad die logische 1 und dem anderen Strompfad die logische 0 zugeordnet ist. Wechselt die Beschaltung der Strompfade jedoch periodisch, so dass auch Perioden existieren, in denen dem kurz- oder quergeschlossenen Strompfad eine logische 0 zugeordnet ist, werden in dieser Periode beide Strompfade auf das Spannungsniveau der logischen 1 gebracht, so dass die Entweder-Oder-Schaltung ein Falsch-Signal und damit einen Fehler ausgibt.

Schließlich entspricht im Betrieb der Sicherheitssteuerung das erste logische Signal zu jedem gegebenen Zeitpunkt dem jeweils anderen logischen Wert als das zweite logische Signal. Mit anderen Worten: Zu jedem gegebenen Zeitpunkt sind die Signale, mit denen die Strompfade beaufschlagt werden, entgegengesetzt. Damit eignet sich nämlich auch jeder beliebige Zeitpunkt als Messzeitpunkt, d.h. die Entweder-Oder-Auswertung kann permanent erfolgen. Sobald eine Betätigung erfolgt oder z.B. ein Querschlussfehler auftritt, wird dieser praktisch instantan erkannt. Auch extrem kurze Betätigungen, die bei einer austastlückenbasierten Erkennung nicht erkannt werden, werden bei diesem Verfahren sofort erkannt. Hierdurch ergibt sich ein besonders hohes Sicherheitsniveau.

Vorteilhafterweise wird dabei bei einem Falsch-Ergebnis der Entweder-Oder-Auswertung ein nicht sicherer Schaltzustand des Meldeelements ermittelt. Sind nämlich die Strompfade kurzgeschlossen, haben beide Strompfade denselben Spannungswert, so dass die Entweder-Oder-Auswertung ein Falsch-Ergebnis liefert. Ein Kurzschluss der Strompfade entspricht dabei einer Betätigung des Meldeelements. Ist das Meldeelement hingegen nicht betätigt, die Strompfade also nicht kurz geschlossen, liefert die Entweder-Oder-Auswertung bei der genannten entgegengesetzten Schaltung stets ein Richtig-Ergebnis.

In vorteilhafter Ausgestaltung des Verfahrens wird beim Ermitteln des nicht sicheren Schaltzustands des Meldeelements durch die Sicherheitssteuerung eine Abschaltung der Stromzufuhr zu einem elektrischen Verbraucher veranlasst. Hierdurch wird eine Gefährdung von Personen sicher verhindert.

Um Querschlüsse besonders schnell erkennen zu können, sollte die Periode, in der die Beschaltung der Strompfade alterniert, möglichst kurz gehalten sein. Je kürzer der Zeitraum, desto schneller kann ggf. ein Querschluss erkannt werden. In vorteilhafter Ausgestaltung des Verfahrens ist die Periode daher kleiner als 1 Minute, vorzugsweise kleiner als 10 Sekunden. Hierdurch kann ein Querschluss spätestens nach 1 Minute bzw. 10 Sekunden erkannt werden.

In vorteilhafter Ausgestaltung ist das Meldeelement eine Trittmatte ist, die derart ausgebildet ist, dass bei einem Betreten der Trittmatte ein Kurzschluss zwischen den beiden Strompfaden verursacht wird.

Eine Sicherheitssteuerung umfasst vorteilhafterweise zwei Signalausgänge und zwei Signaleingänge zum Anschluss eines Meldeelements, eine Signalerzeugungseinheit und eine Signalauswerteeinheit mit einem Entweder-Oder-Element, und ist ausgebildet zum Ausführen des beschriebenen Verfahrens.

Ein Computerprogrammprodukt, welches direkt in den internen Speicher einer Sicherheitssteuerung geladen werden kann umfasst vorteilhafterweise Softwarecodeabschnitte, die, wenn sie auf der Sicherheitssteuerung ausgeführt werden, die Sicherheitssteuerung zum Ausführen des beschriebenen Verfahrens ertüchtigen.

Eine wie oben dargestellt ausgebildete Sicherheitssteuerung umfasst vorteilhafterweise einen Speicher, in den ein derartiges Computerprogrammprodukt geladen ist.

Die mit der Erfindung erzielten Vorteile bestehen insbesondere darin, dass durch die einfache Entweder-Oder-Auswertung in Verbindung mit einer Beaufschlagung der beiden Strompfade eines kurzschlussbildenden Meldeelements mit entgegengesetzten logischen Signalen eine besonders einfache und sichere Erkennung des Betätigungszustands des Meldeelements erreicht wird. Werden die Signale gegengleich alterniert, ist dadurch einerseits eine Erkennung von Querschlüssen und andererseits eine verzögerungsfreie Erkennung des Zustands möglich. Das Verfahren sorgt damit für einen sichereren Betrieb eines elektrischen Verbrauchers, der Gefahrenpotential für den Benutzer aufweist.

Ein Ausführungsbeispiel der Erfindung wird anhand einer Zeichnung näher erläutert. Darin zeigen:
FIG 1 eine schematische Darstellung einer Sicherheitssteuerung,
FIG 2 eine schematische Darstellung der Sicherheitssteuerung mit einer angeschlossenen Trittmatte, und
FIG 3 eine graphische Darstellung der verschiedenen Schaltsignale an Schaltein- und -ausgängen der Sicherheitssteuerung, aufgetragen gegen die Zeit.

Gleiche Teile sind in allen Figuren mit denselben Bezugszeichen versehen.

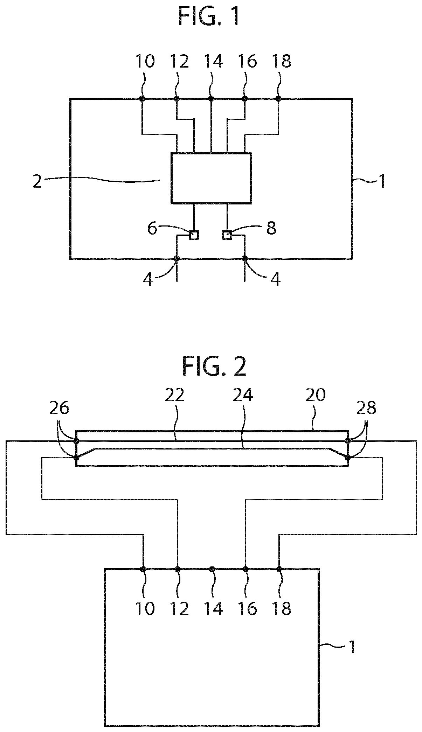

Die FIG 1 zeigt eine Sicherheitssteuerung 1 mit einer zentralen Steuereinheit 2. Die Steuereinheit 2 ist im Ausführungsbeispiel als Mikrocontroller ausgestaltet. Die Sicherheitssteuerung 1 hat zwei Schaltausgänge 4, die in die Stromzufuhr zu einem nicht näher gezeigten elektrischen Verbraucher eingeschaltet sind, der Gefahrenpotential aufweist und daher sicher ausgeschaltet werden soll. Dazu sind in die Verbindung zwischen den Schaltausgängen 4 zwei Relais 6, 8 in Reihe geschaltet. Um den Stromfluss zu erhalten, müssen beide Relais 6, 8 im geschlossenen Zustand sein, sie sind also redundant. Die Relais 6, 8 werden von der Steuereinheit 2 gesteuert.

Um die Funktion des elektrischen Verbrauchers im Gefahrenfall zu unterbrechen oder zumindest zu beeinflussen, sind verschiedene, beispielhaft in der folgenden FIG 2, jedoch nicht in der FIG 1 gezeigte Meldeelemente an die Sicherheitssteuerung 1 anschließbar. Diese können z.B. Not-Aus-Schalter, Lichtschranken, Türpositionsschalter etc. sein. Zum Anschluss dieser Meldeelemente weist das Sicherheitssteuerung zwei weitere Schaltausgänge 10, 12 und drei Schalteingänge 14, 16, 18 auf.

An den Schaltausgängen 10, 12 liegen durch eine kleine positive Gleichspannung dargestellte Signale an, die logischen Zuständen entsprechen. Diese werden von einer Signalerzeugungseinheit innerhalb der Steuereinheit 2 erzeugt und an die Schaltausgänge 10, 12 übergeben. Im Ausführungsbeispiel stellt eine Spannung von +24 V einen logischen Zustand 1 dar, während ein Masseschluss, d.h. eine Spannung von 0 V einen logischen Zustand 0 darstellt. Die Schaltausgänge 10, 12 können, gesteuert durch die Steuereinheit 2, in beliebiger zeitlicher Abfolge mit den den jeweiligen logischen Zuständen entsprechenden Spannungswerten beschaltet werden.

Die an den Schalteingängen 14, 16, 18 anliegenden Spannungswerte werden von der eine entsprechende Signalauswerteeinheit umfassenden Steuereinheit 2 zu einem logischen Signal ausgewertet. Hierfür sind gewisse Spannungsintervalle vorgegeben: So kann z.B. eine anliegende Spannung zwischen +23,5 und +24,5 V stets als logische 1, d.h. ein logischer Wahr-Wert interpretiert werden, während eine Spannung zwischen -0,5 V und +0,5 V als logische 0, d.h. logischer Falsch-Wert interpretiert wird. Liegen die anliegenden Spannungen außerhalb dieser Intervalle, wird ein Fehler ausgegeben und die Relais 6, 8 geöffnet.

Aufgrund der beschriebenen Auswertung wird im Folgenden nur noch von einer Beschaltung der Schaltein- und -ausgänge 10, 12, 14, 16, 18 mit einem logischen Wert, d.h. 0 oder 1 gesprochen, gemeint ist hierbei stets eine Beschaltung mit den jeweils entsprechenden Spannungswerten, die natürlich beliebig gewählt und Logikwerten zugeordnet sein können.

FIG 2 zeigt ein Anwendungsbeispiel der Sicherheitssteuerung 1 im "sicheren" Zustand. Dabei wird aus Gründen der Übersichtlichkeit auf die Darstellung sämtlicher Teile der Sicherheitssteuerung 1 außer der Schaltein- und -ausgänge 10, 12, 14, 16, 18 verzichtet.

FIG 2 zeigt eine Trittmatte 20, die als kurzschlussbildendes Meldeelement ausgelegt ist. Die Trittmatte 20 weist zwei parallele Strompfade 22, 24 auf, die über jeweils einen Eingang 26 und einen Ausgang 28 beschaltbar sind. Derartige, auch als Sicherheits-Schaltmatten bezeichnete Trittmatten 20 dienen der Absicherung größerer Flächen. Sie werden in gefährlichen Arbeitsbereichen an dem genannten elektrischen Verbraucher auf dem Boden ausgelegt. Wird die Trittmatte 20 betreten, erfolgt ein Kurzschluss, d.h. eine elektrische Verbindung zwischen den beiden Strompfaden 22, 24. In der FIG 2 sind die Strompfade 22, 24 getrennt, d.h. die Trittmatte 20 ist nicht betreten.

Die Trittmatte 20 ist derart mit dem Sicherheitssteuerung 1 verbunden, dass Schaltausgang 10 über den ersten Strompfad 22 mit Schalteingang 18 verbunden ist, Schaltausgang 12 über den zweiten Strompfad 24 mit Schalteingang 16.

Schalteingang 14 bleibt unbelegt. Die Verbindung erfolgt dabei über die jeweiligen Eingänge 26 und Ausgänge 28.

Das Beispiel in den FIG 1 und 2 dient nur der Veranschaulichung der Funktionsweise der Sicherheitssteuerung 1 und ist daher stark vereinfacht. In der Realität wird das System weit komplexer sein, die Sicherheitssteuerung 1 kann modular aufgebaut sein, und es werden eine Vielzahl von Schaltein- und ausgängen vorhanden sein, die eine Vielzahl von elektrischen Verbrauchern schalten können und an die eine Vielzahl von Meldeelementen verschiedenster Art angeschlossen werden kann.

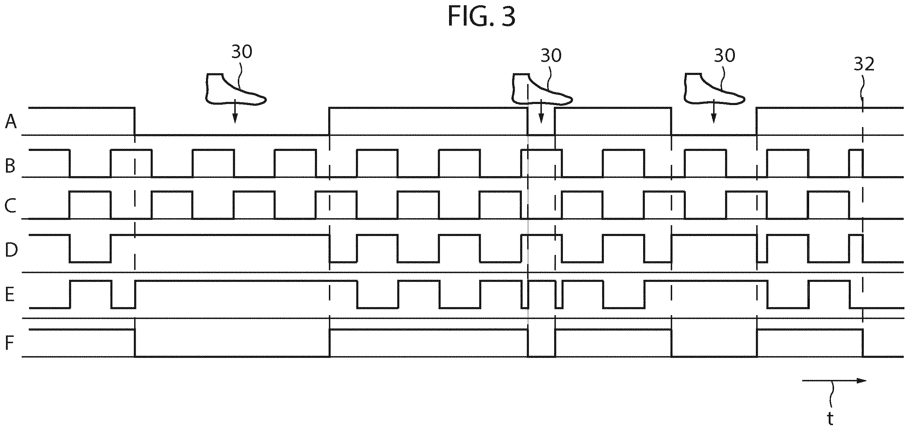

Die Anschlussanordnung und damit letztlich die an den Schaltein- und Ausgängen zu erwartenden Signalkombinationen müssen der Steuereinheit 2 bekannt sein, so dass sie für die jeweilige Kombination die richtige Schaltstellung für die elektrischen Verbraucher veranlasst. Dies geschieht über ein entsprechend in der Steuereinheit 2 hinterlegtes Steuerprogramm. Dessen Funktion im Betrieb wird in der FIG 3 dargestellt.

Die FIG 3 zeigt verschiedene Kurven A, B, C, D, E, F, die jeweils nur zweiwertig sind, d.h. zwei verschiedene Werte annehmen können, aufgetragen gegen die Zeit t. Jede der Kurven hat zu einem gegebenen Zeitpunkt entweder einen Wert 0 oder einen von 0 verschiedenen positiven Wert. Deren Bedeutung unterscheidet sich in jedem der Graphen A, B, C, D, E, F und wird im Folgenden detailliert erläutert.

Die Kurve A zeigt den Schaltzustand der Trittmatte 20, d.h. ob die Trittmatte 20 betreten wird, oder nicht. Ein Wert von 0 entspricht hier einem Betreten der Trittmatte 20, angezeigt durch jeweils einen Fuss 30, ein positiver Wert entspricht einem Zustand, in dem die Trittmatte 20 nicht betreten wird.

Die Schaltausgänge 10, 12 der Sicherheitssteuerung 1 werden nun periodisch mit einem logischen Wert von 0 und 1 beschaltet. Im Ausführungsbeispiel beträgt die Periodenlänge hierbei 200 ms, d.h. für 100 ms wird der Schaltausgang 10 mit einem logischen Wert 0 beschaltet, entsprechend 0 V Spannung, anschließend für 100 ms mit einem logischen Wert 1, entsprechend +24 V Spannung. Danach beginnt eine weitere, gleiche Periode usw. Das Signal für den Schaltausgang 10 zeigt Kurve B in FIG 3. Der Schaltausgang 12 wird dabei stets genau entgegengesetzt beschaltet, d.h. wenn der Schaltausgang 10 den logischen Wert 1 hat, wird der Schaltausgang 12 mit dem logischen Wert 0 beschaltet und umgekehrt. Es ergibt sich praktische derselbe, jedoch um 100 ms versetzte und dadurch gegengleiche Periodenverlauf. Dieses Signal für den Schaltausgang 12 zeigt Kurve C in FIG 3. In den Kurven B bis F beschreibt ein positiver Wert stets den logischen Wert 1 und ein Nullwert stets den logischen Wert 0.

Die Kurven D und E in FIG 3 zeigen nun das mit dem in Kurve A dargestellten Betreten der Trittmatte 20 erzeugte Signal an den Ausgängen 28 der Trittmatte 20. Kurve D zeigt das Signal am Ausgang 28 des Strompfads 22, Kurve E zeigt das Signal am Ausgang 28 des Strompfads 24. In Phasen des Betretens der Trittmatte 20 werden die Strompfade 22, 24 kurzgeschlossen. Da stets einer der beiden Strompfade 22, 24 bei der beschriebenen Schaltung einen logischen Wert 1, d.h. +24 V Spannung führt, führt ein Kurzschließen dazu, dass dieses Signal auf beide Strompfade 22, 24 übertragen wird. Während den Phasen des Betretens der Trittmatte haben sowohl Kurve D als auch Kurve E den logischen Wert 1, während sie in den Zeiten zwischen diesen Phasen das beschriebene periodisch abwechselnde Signal der Schaltausgänge 10, 12 zeigen.

Das Signal der Ausgänge 28 wird an den Schalteingängen 16, 18 aufgenommen und in der Steuereinheit 2 weiterverarbeitet. Es durchläuft dazu zunächst einen nicht näher dargestellten Eingangsfilter, der die oben beschriebene Zuordnung von Spannungen zu Logikwerten vornimmt. Es ergibt sich so ein digitales Logiksignal, das von der Steuereinheit 2 verarbeitbar ist. Das Logiksignal, welches aus den Signalen an den Eingängen 16, 18 abgeleitet ist, entspricht dem in den Kurven D bzw. E aufgetragenen. Es zeigt Phasen übereinstimmender Logikwerte 1 in Kurve D und Kurve E, die mit dem in Kurve A dargestellten Betreten der Trittmatte 20 zusammenfallen und durch die dadurch verursachten Kurzschlüsse zwischen den Strompfaden 22, 24 in der Trittmatte 20 erzeugt werden.

Das nun auch innerhalb der Steuereinheit 2 in ein digitales Eingangssignal übersetzte Signal der Kurven D und E wird nun mittels eines logischen XOR-Elements, d.h. eines Entweder-Oder-Elements ausgewertet. Die XOR-Logik ermittelt aus zwei logischen Eingangssignalen ein logisches Ausgangssignal in der Art, dass bei gleichen Eingangssignalen (z.B. zwei mal 1) eine 0, d.h. ein Falsch-Ergebnis ermittelt wird, während bei unterschiedlichen Eingangssignalen (ein Signal 0, ein Signal 1) eine 1, d.h. ein Wahr-Ergebnis ermitteltwird.

Das aus dem Signal der Kurven D und E mittels der Entweder-Oder-Auswertung ermittelte Ergebnis ist in Kurve F dargestellt. Aufgrund der Struktur der Eingangssignale ergibt sich hierbei ein genaues Abbild des Zustands der Trittmatte 20. Bei einer nicht betretenen Trittmatte 20 bleibt es nämlich bei den zwar alternierenden, aber stets entgegengesetzten Signalen, die in die Trittmatte 20 über die Eingänge 26 eingespeist werden, und die damit stets einen Wahr-Wert bei der XOR-Logik erzeugen. Wird die Trittmatte 20 hingegen betreten, werden die Strompfade 22, 24 kurzgeschlossen und es ergibt sich ein Falsch-Signal.

Das Falsch-Signal wird in der Auswertelogik auch erreicht, wenn ein sogenannter Stuck-At-Fehler auftritt, d.h. ein Kurzschluss einer der beiden Strompfade 22, 24 nach +24 V oder nach Masse (0 V). Dadurch verbleibt einer der beiden Strompfade 22, 24 stets auf dem kurzgeschlossenen Niveau. Je nach Position in der aktuellen Periode zum Fehlerzeitpunkt hat dann aber spätestens nach einer halben Periode der andere Strompfad 22, 24 das gleiche Spannungsniveau. Die XOR-Logik gibt dann einen Falsch-Wert aus. Stuck-At-Fehler werden somit nach spätestens einer halben Periodendauer erkannt.

Bei einem Leitungsbruch zwischen Trittmatte 20 und Sicherheitssteuerung 1, dargestellt durch die Linie 32 in FIG 3, sinken die Spannungswerte an beiden Schalteingängen 16, 18 auf 0 V ab, da keine Spannung aus der Trittmatte 20 mehr an den Schalteingängen 16, 18 ankommt. Beide Schalteingänge 16, 18 sind dann auf dem selben Spannungsniveau und die XOR-Logik ermittelt einen Falsch-Wert. Leitungsbrüche werden somit sofort erkannt.

In jedem Fall wird bei einem Falsch-Ergebnis eine sicherheitsgerichtete Abschaltung der Stromversorgung zum elektrischen Verbraucher über die Relais 6, 8 vorgenommen. Damit erfolgt dies sowohl bei einem Betreten der Trittmatte 20 als auch bei Fehlern in der Verkabelung.

Durch die gezeigte Sicherheitssteuerung 1 und das gezeigte Verfahren mit einer Auswertung über eine XOR-Logik wird so in technisch einfacher Weise eine besonders sichere Überwachung der Trittmatte 20 ermöglicht. Der Vorteil der gezeigten antivalenten Ansteuerung in Verbindung mit der XOR-Auswertung ist, dass eine Betätigung der Trittmatte 20 sofort erkannt wird, unabhängig von der Periodendauer der Testsignale. Außerdem können aufgrund der XOR-Auswertung, auch bei kurzzeitiger Betätigung, keine Ablauffehler entstehen.

### Bezugszeichenliste

- 1: Sicherheitssteuerung
- 2: Steuereinheit
- 4: Schaltausgang
- 6, 8: Relais
- 10, 12: Schaltausgang
- 14, 16, 18: Schalteingang
- 20: Trittmatte
- 22, 24: Strompfad
- 26: Eingang
- 28: Ausgang
- 30: Fuss
- 32: Linie
- A, B, C D, E, F: Kurve
- t: Zeit

## Patentansprüche

1. Verfahren zur Ermittlung des Schaltzustands eines kurzschlussbildenden Meldeelements (20) mit einem ersten Strompfad (22) und einem zweiten Strompfad (24), die bei Betätigung des Meldeelements (20) kurzgeschlossen werden, bei dem durch eine Sicherheitssteuerung (1) ein erstes logisches Signal (10) in einen Eingang (26) des ersten Strompfades (22) eingespeist wird und ein zweites logisches Signal (12) in einen Eingang (26) des zweiten Strompfades (24) eingespeist wird, wobei die logischen Signale an den Ausgängen (28) der Strompfade (22, 24) von der Sicherheitssteuerung (1) ausgelesen werden, wobei zu einem gegebenen Zeitpunkt das erste eingespeiste logische Signal einer 0 entspricht und das zweite eingespeiste logische Signal einer 1 entspricht, die eingespeisten Signale periodisch zwischen einer 1 und einer 0 wechseln, im Betrieb der Sicherheitssteuerung (1) das erste logische Signal zu jedem gegebenen Zeitpunkt dem jeweils anderen logischen Wert entspricht als das zweite logische Signal, und der Zustand des Meldeelements (20) von der Sicherheitssteuerung (1) mittels einer Entweder-Oder-Auswertung der ausgelesenen logischen Signale ermittelt wird.

2. Verfahren nach Anspruch 1 bei dem bei einem Falsch-Ergebnis der Entweder-Oder-Auswertung ein nicht sicherer Schaltzustand des Meldeelements (20) ermittelt wird.

3. Verfahren nach Anspruch 2, bei dem beim Ermitteln des nicht sicheren Schaltzustands des Meldeelements (20) durch die Sicherheitssteuerung (1) eine Abschaltung der Stromzufuhr zu einem elektrischen Verbraucher veranlasst wird.

4. Verfahren nach einem der vorhergehenden Ansprüche, bei dem die Periode kleiner als 1 Minute, vorzugsweise kleiner als 10 Sekunden ist.

5. Verfahren nach einem der vorhergehenden Ansprüche, bei dem das Meldeelement (20) eine Trittmatte (20) ist, die derart ausgebildet ist, dass bei einem Betreten der Trittmatte (20) ein Kurzschluss zwischen den beiden Strompfaden (22, 24) verursacht wird.

6. Sicherheitssteuerung (1), umfassend zwei Signalausgänge (10, 12) und zwei Signaleingänge (16, 18) zum Anschluss eines Meldeelements (20), eine Signalerzeugungseinheit und eine Signalauswerteeinheit mit einem Entweder-Oder-Element, ausgebildet zum Ausführen des Verfahrens nach einem der vorhergehenden Ansprüche.

7. Computerprogrammprodukt, welches direkt in den internen Speicher einer Sicherheitssteuerung (1) geladen werden kann und Softwarecodeabschnitte umfasst, die, wenn sie auf der Sicherheitssteuerung (1) ausgeführt werden, die Sicherheitssteuerung (1) zum Ausführen des Verfahrens nach einem der Ansprüche 1 bis 5 ertüchtigen.

8. Sicherheitssteuerung (1) nach Anspruch 6, umfassend einen Speicher, in den das Computerprogrammprodukt nach Anspruch 7 geladen ist.

## Claims

1. Method for determining the state of operation of a reporting element (20) that forms a short circuit and comprises a first current path (22) and a second current path (24) which are short-circuited when the reporting element (20) is actuated, in which method a first logical signal (10) is applied to an input (26) of the first current path (22) and a second logical signal (12) is applied to an input (26) of the second current path (24) by means of a safety controller (1), wherein the logical signals are read out at the outputs (28) of the current paths (22, 24) by the safety controller (1), wherein, at a given point in time, the first logical signal applied corresponds to a 0 and the second logical signal applied corresponds to a 1, the applied signals periodically alternate between a 1 and a 0, the first logical signal corresponds to the logical value that is in each case different from that of the second logical signal at any given point in time during operation of the safety controller (1), and the state of the reporting element (20) is determined by the safety controller (1) by means of an either-or evaluation of the read-out logical signals.

2. Method according to claim 1, wherein the state of operation of the reporting element (20) is determined to be unsafe in the event of a false result of the either-or evaluation.

3. Method according to claim 2, wherein the current supply to an electrical load is switched off when the state of operation of the reporting element (20) has been determined to be unsafe by the safety controller (1).

4. Method according to any of the preceding claims, wherein the cycle is less than 1 minute, preferably less than 10 seconds.

5. Method according to any of the preceding claims, wherein the reporting element (20) is a pressure mat (20) that is designed to cause a short circuit between the two current paths (22, 24) when the pressure mat (20) is stepped on.

6. Safety controller (1) comprising two signal outputs (10, 12) and two signal inputs (16, 18) for connecting a reporting element (20), a signal generation unit and a signal evaluation unit comprising an either-or element, designed to carry out the method according to any of the preceding claims.

7. Computer program product which can be loaded directly into the internal memory of a safety controller (1) and comprises software code portions which, when implemented on the safety controller (1), instruct the safety controller (1) to carry out the method according to any of claims 1 to 5.

8. Safety controller (1) according to claim 6, comprising a memory into which the computer program product according to claim 7 is loaded.

## Revendications

1. Procédé destiné à la détection de l'état de fonctionnement d'un élément de signalisation (20) générateur de court-circuit avec un premier trajet de courant (22) et un deuxième trajet de courant (24), lesquels sont court-circuités lors de l'actionnement de l'élément de signalisation (20), dans lequel, par l'intermédiaire d'une commande de sécurité (1), un premier signal (10) logique est alimenté dans une entrée (26) du premier trajet de courant (22) et un deuxième signal (12) logique est alimenté dans une entrée (26) du deuxième trajet de courant (24), dans lequel les signaux logiques sont lus par la commande de sécurité (1) au niveau des sorties (28) des trajets de courant (22, 24), dans lequel, à un moment donné, le premier signal logique alimenté correspond à un 0 et le deuxième signal logique alimenté correspond à un 1, les signaux alimentés alternent périodiquement entre un 1 et un 0, le premier signal logique correspond respectivement, à chaque moment donné, à l'autre valeur logique que le deuxième signal logique, lorsque la commande de sécurité (1) est en cours de fonctionnement, et l'état de l'élément de signalisation (20) est détecté par la commande de sécurité (1) au moyen d'une évaluation de type « soit, soit » des signaux logiques lus.

2. Procédé selon la revendication 1 dans lequel un état de fonctionnement non sécurisé de l'élément de signalisation (20) est détecté en cas de résultat erroné de l'évaluation de type « soit, soit ».

3. Procédé selon la revendication 2, dans lequel une déconnexion de l'alimentation en courant vers un consommateur électrique est provoquée en cas de détection de l'état de fonctionnement non sécurisé de l'élément de signalisation (20) par la commande de sécurité (1).

4. Procédé selon l'une des revendications précédentes, dans lequel la période est inférieure à 1 minute, de préférence inférieure à 10 secondes.

5. Procédé selon l'une des revendications précédentes, dans lequel l'élément de signalisation (20) est un tapis de contact (20), lequel est conçu de telle sorte qu'un court-circuit est provoqué entre les deux trajets de courant (22, 24) en cas de contact physique sur le tapis de contact (20).

6. Commande de sécurité (1), comprenant deux sorties de signaux (10, 12) et deux entrées de signaux (16, 18) en vue de la connexion d'un élément de signalisation (20), une unité de génération de signaux et une unité d'évaluation des signaux avec un élément de type « soit, soit », conçu en vue de la réalisation du procédé selon l'une des revendications précédentes.

7. Produit de programme informatique qui peut être chargé directement dans une mémoire interne d'une commande de sécurité (1) et qui comprend des sections de code de logiciel qui, lorsqu'elles sont exécutées sur la commande de sécurité (1), stimulent la commande de sécurité (1) en vue de la réalisation du procédé selon l'une des revendications 1 à 5.

8. Commande de sécurité (1) selon la revendication 6, comprenant une mémoire, dans laquelle est chargé le produit de programme informatique selon la revendication 7.
